# EUROPEAN PATENT APPLICATION

(11) **EP 2 757 495 A1**
(43) Date of publication of application: **23.07.2014**
(21) Application number: 14151934.8
(22) Date of filing: 21.01.2014
(51) Int. Cl.: G06F 17/50

(54) **System for parameterized finite element analysis**

(30) Priority: 22.01.2013 IT GE20130008
(71) Applicant: L.T. Calcoli SRL, 23807 Merate (LC) (IT)
(72) Inventor: Lucca, Flavio, 23807 Merate (LC) (IT); Sitzia, Daniela, 09017 Sant'Antioco (CI) (IT)
(74) Representative: Karaghiosoff, Giorgio Alessandro

(57) **Abstract**

A Finite Element Modeling (FEM) system, providing Finite Element Analysis (FEA) for numerical modeling of physical systems in a variety of engineering disciplines, comprising means for generating a finite element model, data processing means, result delivering means for delivering the results so obtained to a user, wherein the finite element model generated is further parameterized, and a user interface is provided for changing the parameters of the finite element model and for entering such parameters into said data processing means.

## Description

The present invention relates to a Finite Element Modeling (FEM) system, providing Finite Element Analysis (FEA) for numerical modeling of physical systems in a variety of engineering disciplines, comprising means for generating a finite element model, data processing means, result delivering means for delivering the results so obtained to a user.

Systems of this type are known and used, and allow generation and testing of a finite element model.

Usually, these systems are used by users who do not have adequate computational resources for independent Finite Element Analysis and request the help of a service provider that uses the 3D design of the user to generate the finite element model and to process data by generating the mesh and executing calculations, whereupon he sends the results to the user.

Once the user has received the results, he/she often needs to make changes to certain parameters of interest of the finite element model.

In order to do this, he/she has to contact the service provider again, for the latter to generate a new finite element model, with partial or no use of the previously developed model as a reference, and tests it to eventually provide the new results to the user.

This is a time consuming process, involving high costs for remuneration of the service provider, due to the intensive work required of the service provider for making changes to the finite element model.

The expensiveness of the process is even more apparent in that the service provider does not know the object of the finite element model and its operational environment in detail, whereby he needs time for full understanding of the requested changes.

Parameterized finite element models are known in the art, but software interaction is required for these prior art models to obtain results based on changed parameters, whereby they have to know the software to a certain extent, in terms of both syntax and interfaces. Nevertheless, in most cases, final users do not have this knowledge and the advantage of parameterization of finite element models is restricted to the scope of activity of service providing specialists, and the final user is excluded therefrom.

The present invention obviates the problems of the prior art by providing a system as described hereinbefore, wherein the finite element model generated is further parameterized, and a user interface is provided for changing the parameters of the finite element model and for entering such parameters into the data processing means.

This will relieve the user from the need of directly contacting the service provider for any changes to be made to the first implementation of the finite element model.

Thus, once the first results have been obtained, the user is allowed to change parameters through the above-mentioned user interface and enter the changes without directly contacting the service provider and without recreating a Finite Element model anew.

In one advantageous embodiment of the invention, for more convenient and easier change of parameters by the final user, the numerical data for the individual parameters, associated with the identification of the individual parameters themselves, are entered through a file having any extension whatever among a plurality of predetermined file extensions and an interpreter is provided upstream from the data input in the parameterized model, for identifying the individual parameters and the numerical values uniquely associated therewith and defined by the user within the file, and for providing in turn parameter identifier-numerical data pairs to the input of the finite element model, according to the syntax and as provided by the corresponding calculation program in said finite element model.

Advantageously, the calculation output is provided in the form of a graphic model representation file having the list of parameters with the corresponding values associated therewith, both for user-defined parameters and for the parameters they may result from model calculation.

Examples of input files for entering changeable numerical parameter values in a finite element model include, among the files that are most frequently used by unskilled users, .DOC, .TXT, .XLS, .PDF, .XML files and many others.

In one exemplary embodiment, the data processing means comprise one or more remote computing units comprising one or more storage units and processor means for executing a logic program, said executed logic program allowing the system to carry out the steps of:
a) generating the finite element model mesh;
b) processing data;
c) delivering the results to a user;
   and the optional and repeatable steps of:
d) changing the parameters of the finite element model by the user;
e) generating the further finite element model mesh;
f) further processing data;
g) delivering the results so obtained.

As mentioned above, the step d) may comprise:
encoding unique pairs of individual changeable parameter identifiers and corresponding numerical values in a file having a predetermined format;
processing said file by an interpreter and recognizing the individual parameters and the corresponding numerical values;
converting, by said interpreter, said parameter identifiers and the corresponding numerical values into input data expressed in the language of the calculation program of the finite element model;
transmitting these parameter identifiers and the corresponding data to the input interface of the calculation program of the finite element model.

Still according to a preferred embodiment, results may be delivered in alphanumeric form as data tables or, instead of or in addition to the above, in graphic form, with one or more images of the calculated model being displayed.

In a further exemplary embodiment, these one or more storage units comprise an authentication storage unit, with a user identification database, a storage unit for data concerning the finite element model of a predetermined user, a storage unit for parameters set via said user interface and a storage unit for result deliveries to the user.

Advantageously, the settable parameters are only part of the total parameters of the finite element model, and are decided beforehand by the user and the service provider, before generation of the finite element model.

Before generation of the model, the user already knows which parameters may be changed during design and will ask the service provider to maintain them in the settable state.

Alternatively, means may be provided for defining the user-settable parameters, which are directly connected with the data processing means.

In a further exemplary embodiment, the data processing means are of the cloud-computing type.

This involves the use of network-based hardware/software resources, which are virtually provided as a unit for interaction with the client.

The above mentioned storage units and processing means are distributed over a predetermined number of coordinated machines, for network access.

In a further exemplary embodiment, the user interface and the result delivering means are included in a Web portal.

Thus, the user may access the results and/or set the free parameters via the Internet, i.e. from any Web-connected station.

In one embodiment, the above mentioned one or more storage units include a unit for recording the steps carried out by the processing means into a log that can be accessed through said Web portal.

Therefore, all the actions taken will be tracked, and errors may be located.

In a further embodiment, the above mentioned one or more storage units comprise a unit for storage of a data list concerning base elements that can be used in said finite element model, some parameters of said base elements being at least partially fixed and/or at least partially user-defined elements.

This list may be organized as a library, and the base elements may be commonly used elements, such as models of widely used mechanical parts.

These and other features and advantages of the present invention will appear more clearly from the following description of a few embodiments, illustrated in the annexed drawings, in which:
Fig. 1 is a diagram illustrating a prior art system;
Fig. 2 is a diagram illustrating a system of the present invention;
Figs. 3 to 10 show the pages of the Internet portal of the present invention.
Figure 11 is a basic block diagram of a data input interface that uses an interpreter.

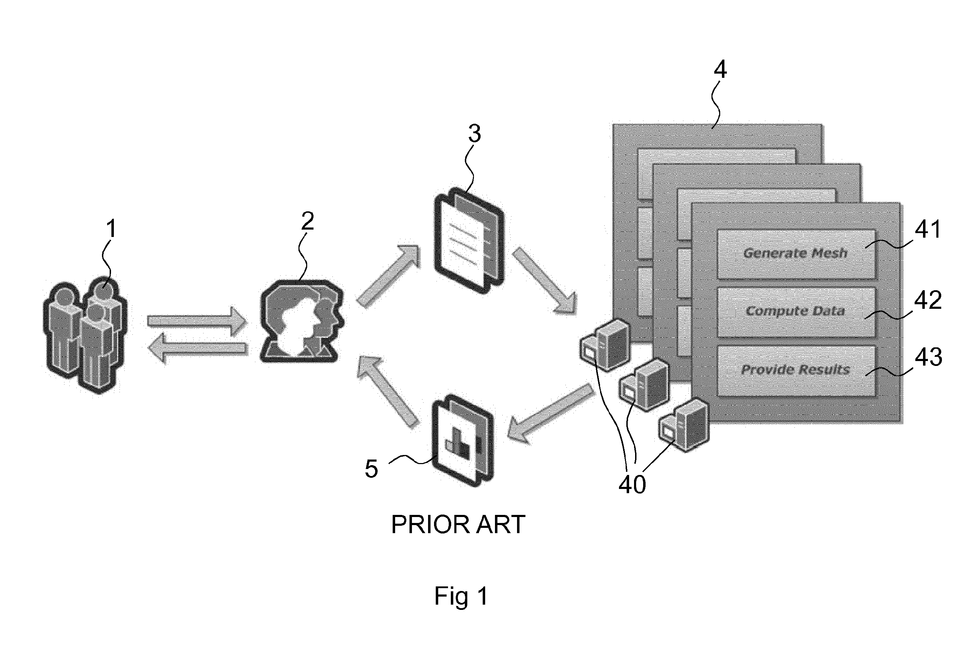

Figure 1 is a schematic view of a prior art finite element model processing system, in which one or more users 1 ask a service provider 2 for a finite element analysis service, and typically provide a three-dimensional design.

The service provider 2 develops a finite element model 3 and processes it using processing means 4, which comprise one or more computing machines or units 40.

The processing means 4 comprise mesh generating means 42, computing means 42, result delivering means 43.

Thus, the results 5 are obtained by the service provider 2, who forwards them to the user 1.

When the user 1 needs to change the model, he/she contacts the service provider 2 with the changes to be made. The service provider 2 creates a new finite element model, which is also processed, and the new results are forwarded to the user 1.

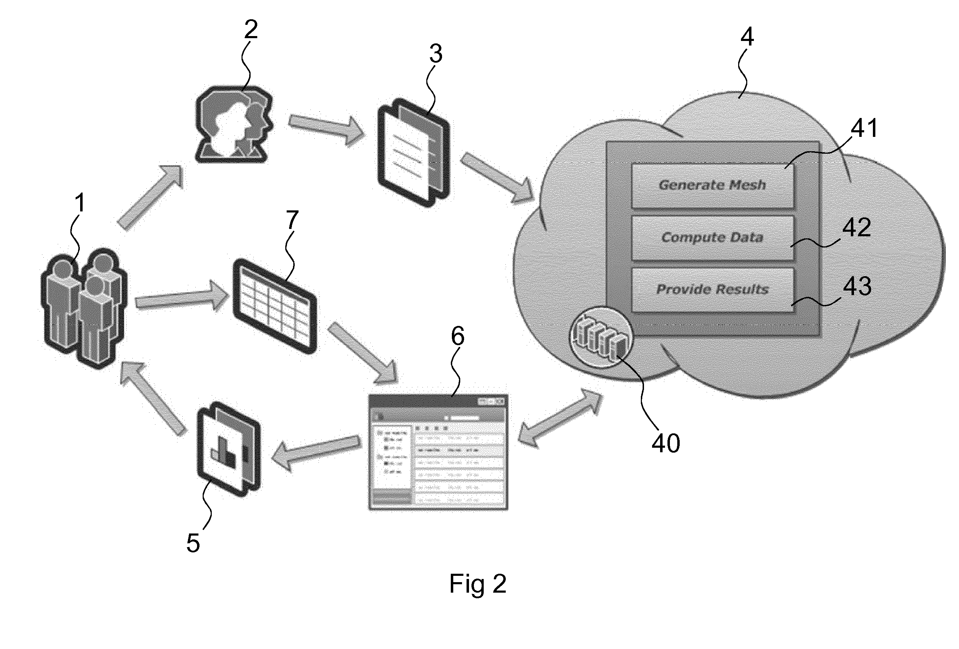

In the system of the present invention, as schematically shown in Figure 2, the client initially interfaces with the service provider 2 to create a finite element model 3, which is generated in a parameterized manner, i.e. has 7 changeable parameters 7.

The service provider 2 first defines with the user 1 the variable geometric parameters, such as length, height, thickness, volume, etc.

Then, the service provider 2 defines with the user 1 the physical and load-related variables, such as the type of material, forces, thermal and electromagnetic and other loads, temperatures, etc.

Finally, the service provider 2 defines with the user 1 the output variables, such as mechanical analyses, stresses, strains, yield according to Von Mises criterion, displacements, sections, points of view to be used for result mapping, etc.

Then, the finite element model 3 is sent to data processing means 4, which are of the cloud-computing type and comprise a plurality of remote computing machines or units 40. The remote computing units 40 comprise one or more storage units and processor means for executing a logic program.

Then, the parameterized finite element model is processed by generating a finite element model mesh. This is followed by all data processing proper. The results so obtained 5 are finally made available and/or delivered to the user 1 through a Web portal 6 that the user may access via login.

Once the user has received the results 5, he/she may decide, if needed, to change certain parameters 6 of the finite element model.

Therefore the user 1 accesses the Web portal 6 and changes the parameters of interest of the finite element model.

The model so changed is entered again into the data processing means 4, in which the further finite element model mesh is created and further data processing is carried out.

The results 5 so obtained are finally made available on the Web portal and hence delivered to the user 1.

The changes may be made through various steps, with one or more parameters being changed at the same time, or the same parameter being changed multiple times.

The Web portal 6 allows authenticated access 1 by the user to his/her resources, namely the previously loaded finite element models.

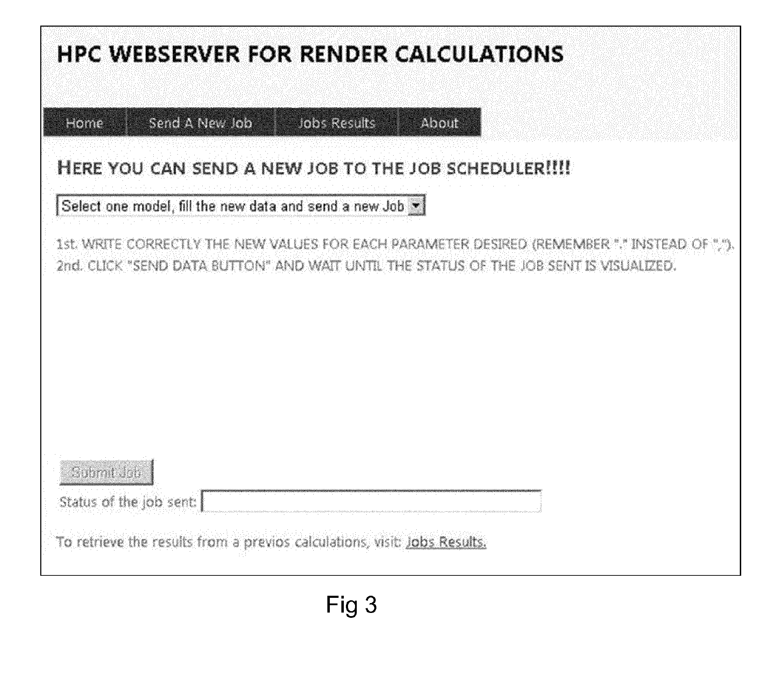

A non-limiting exemplary embodiment of the Web portal 6 is shown in Figures 3 to 10.

Once the user 1 has logged into the Web portal 6, a drop-down list of loaded models is displayed, in the screen as shown in Figure 3.

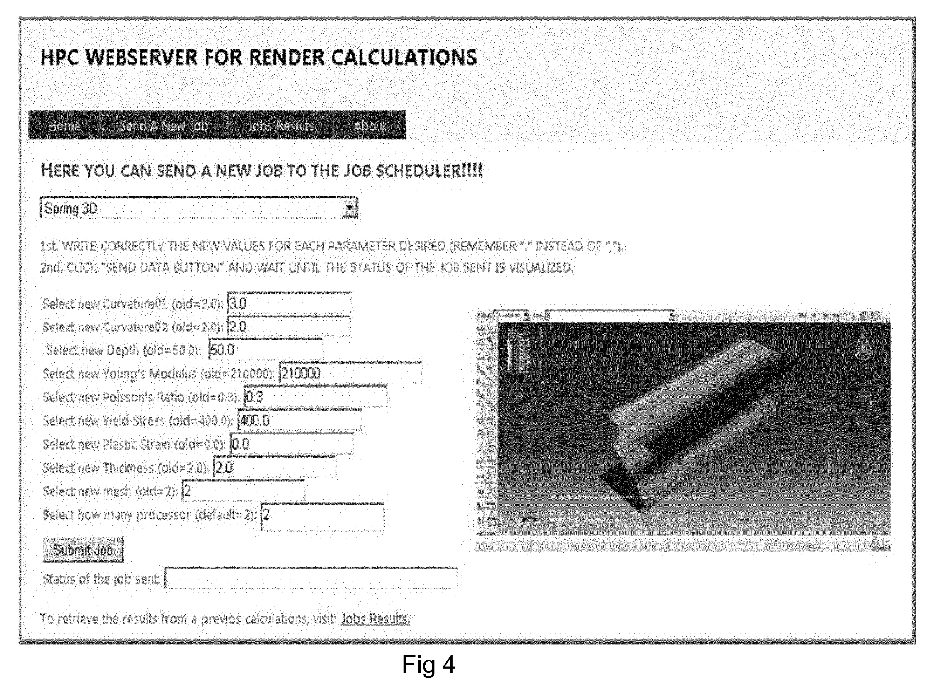

The user 1 selects the model whose parameters are to be changed, and accesses the screen as shown in Figure 4, where the changeable parameters are displayed, with the possibility of entering new values.

The previously set values are indicated for each parameter.

After typing the changed values, the user 1 clicks the button "Submit Job" and the new values are entered into the processing means 4, which perform the required calculations.

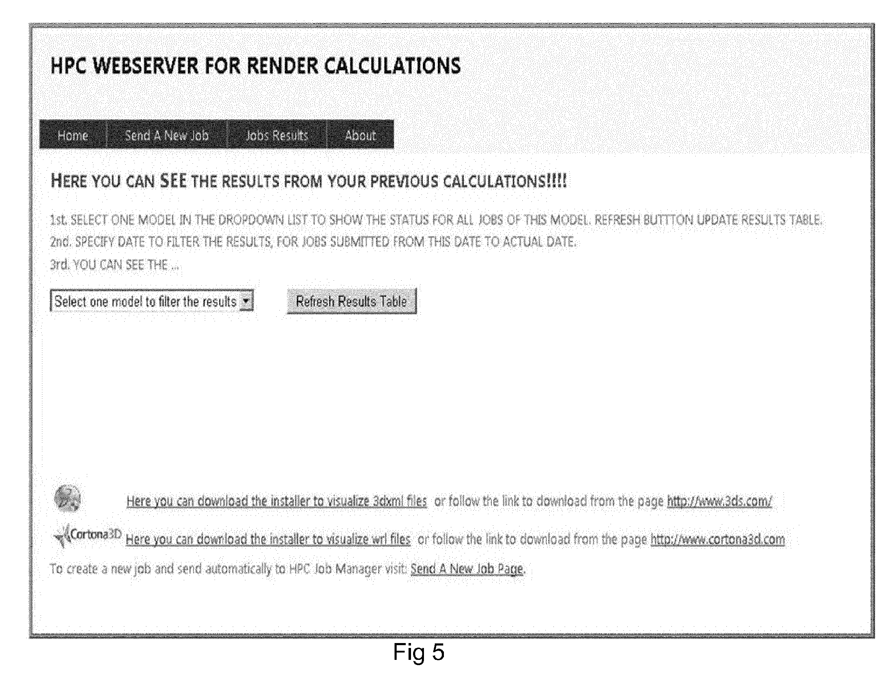

Then, by selecting the "Job Results" tab, the user accesses the results screen, as shown in Figure 5.

The finite element model of interest may be selected from a drop-down list, to display all the Jobs, i.e. the results of the various processing operations.

The results may be further filtered by date, to display all the Jobs from a date of interest to the current date.

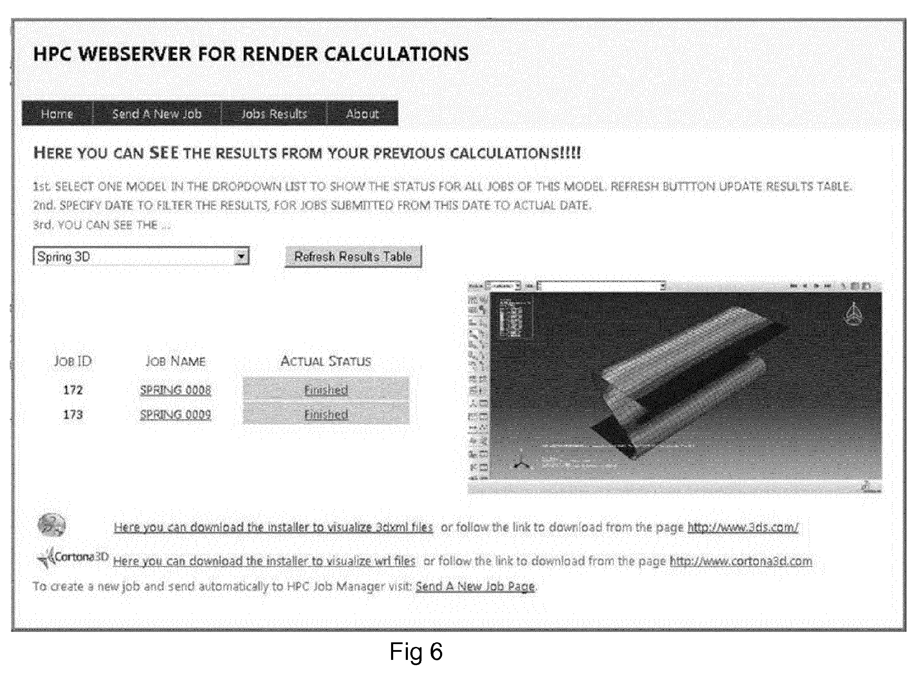

Once the model of interest is selected and the button "Refresh Results Table" is pressed, the results are accessed, as shown in Figure 6, with all the Jobs listed with respective status indications, such as "finished" if the Job is completed, "canceled" if the Job has been canceled by the user 1 or "aborted" if the system has found an anomaly and aborted the Job.

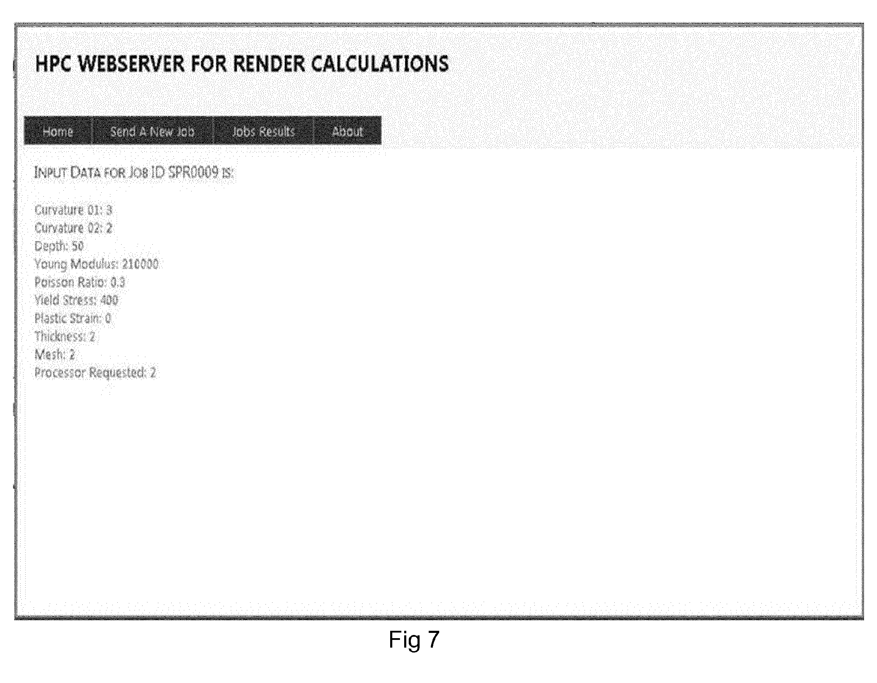

By selecting the desired job from the Job Name list, the user 1 accesses the settable parameters defined for the selected Job, as shown in Figure 7.

As shown in the figures, the parameters may include, for instance, curvature values, Young's modulus, Poisson's modulus, thickness, etc.

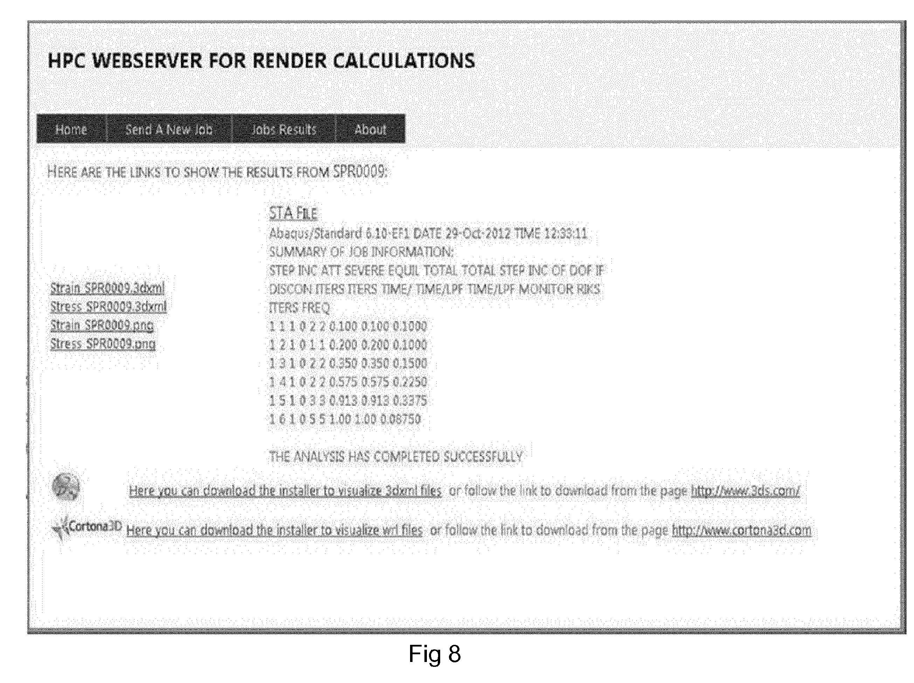

By selecting the desired item from the Actual Status list in the screen of Figure 6, the user 1 accesses the log and output files of the results for the selected Job, as shown in Figure 8.

Finally, the obtained results may be displayed as images, by selecting the file type.

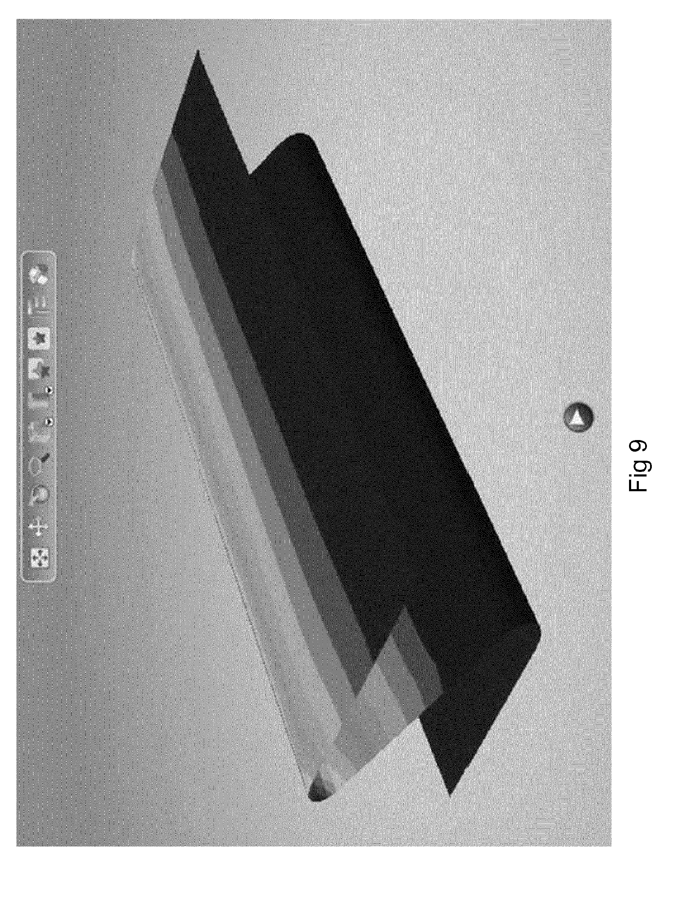

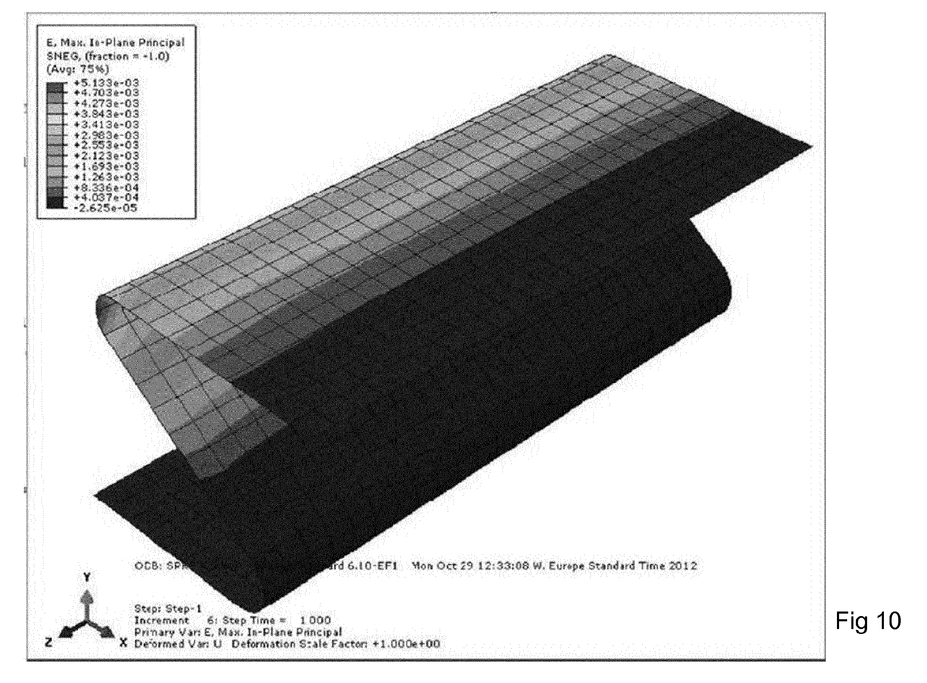

Figure 9 shows a .3dxml file, whereas Figure 10 shows a .png file.

The files may be directly displayed on the Web portal or locally downloaded by the user 1.

Advantageously, the views available to the user are agreed beforehand by the user and the service provider, to restrict data transmission during display to the data required for such views.

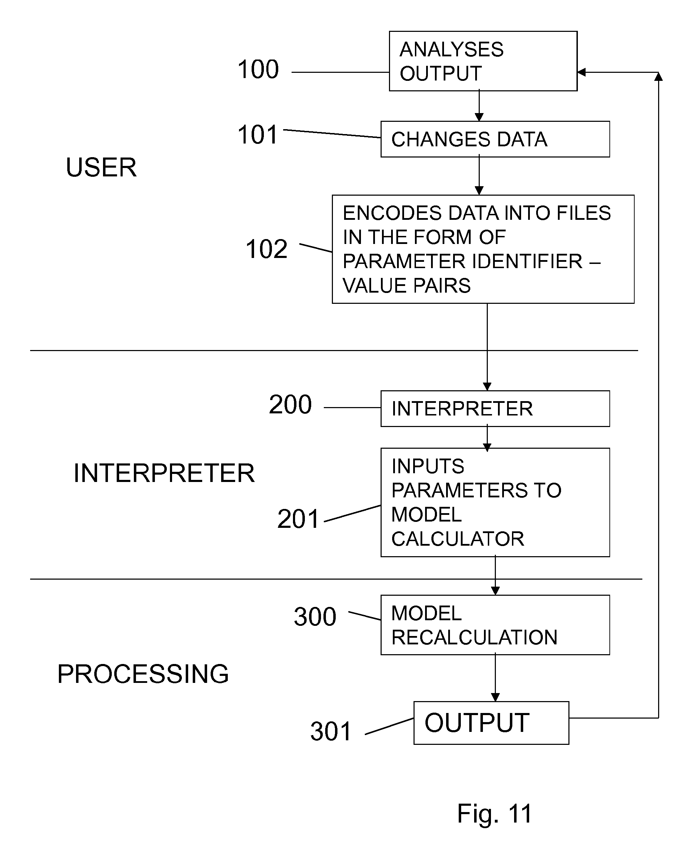

According to an improvement as shown in Figure 11, the numerical values for the changeable parameters of a model are entered in any of the currently widespread formats, such as text, excel, html or other formats, and may be read by an interpreter that converts them into inputs expressed in the language of the calculation program of the model.

In a first possible variant, as shown in Figure 11, after an output analysis 100 performed by the user, the values of one or more parameters are changed, as shown in step 101. The user encodes these values in unique association with a unique identification key for the corresponding parameter in the form of any file, e.g. a document file, a spreadsheet file, or the like, as shown at 102. At the interpreter 200, the program analyzes the file data, recognizes the parameter identification keys and the corresponding numerical data and converts this information into input data readable by the calculation program of the model, as shown at 201. At 300, in the processing step, the software recalculates the model based on the new parameters using a finite element model that has been parameterized as described above and provides an output 301 that may be of various types, as described above.

Nevertheless, the example described for simplicity in combination with a user-generated input file and provided to the interpreter may also find direct application, i.e. the value input interface may be launched on line by the user that connects to the computation server. In this case, the user may select a type of interface program for inputting parameter values, e.g. an input program for text documents, spreadsheets, databases or html. In both variants as described above, the technical problem that has been solved is to avoid the need for a user to know the calculation program of the model and how parameters have to be entered therein, and allowing him/her to simply operate using, as interfaces, programs for generating common office suite files, no special knowledge of any part of computation program of the model being required.

## Claims

1. A Finite Element Modeling (FEM) system, providing Finite Element Analysis (FEA) for numerical modeling of physical systems in a variety of engineering disciplines, comprising means for generating a finite element model (3), data processing means (4), result delivering means (43) for delivering the results so obtained to a user,
**characterized in that**
the finite element model so generated (3) is parameterized, and a user interface (6) is provided for changing the parameters (7) of the finite element model (3) and for entering such parameters (7) into said data processing means (4).

2. A system as claimed in claim 1, wherein the numerical data for the individual parameters, associated with the identification of the individual parameters themselves, are entered through a file having any extension whatever among a plurality of predetermined file extensions and an interpreter is provided upstream from the data input in the parameterized model, for identifying the individual parameters and the numerical values uniquely associated therewith and defined by the user within the file, and for providing in turn parameter identifier-numerical data pairs to the input of the finite element model, according to the syntax and as provided by the corresponding calculation program in said finite element model.

3. A system as claimed in claim 1, wherein the user interface is provided in combination with or consists of a data input program, such as a text generating program, or a spreadsheet or a database, a html program, which is started as desired by the user for inputting data for the changed parameters, i.e. an identification key for each parameter and the corresponding numerical value, and wherein the data is read, identified and converted into the format of the calculation program of the model by an interpreter/converter program.

4. A system as claimed in any of claims 1 and 3, wherein said data processing means (4) include one or more remote computing units (40) comprising one or more storage units and processor means for executing a logic program, said executed logic program allowing the system to carry out the steps of:
a) generating the finite element model mesh;
b) processing data;
c) delivering the results to a user;
and the optional and repeatable steps of:
d) changing the parameters of the finite element model by the user;
e) generating the further finite element model mesh;
f) further processing data;
g) delivering the results so obtained.

5. A system as claimed in claim 4, wherein the step d) may comprise:
encoding unique pairs of individual changeable parameter identifiers and corresponding numerical values in a file having a predetermined format;
processing said file by an interpreter and recognizing the individual parameters and the corresponding numerical values;
converting, by said interpreter, said parameter identifiers and the corresponding numerical values into input data expressed in the language of the calculation program of the finite element model;
transmitting these parameter identifiers and the corresponding data to the input interface of the calculation program of the finite element model.

6. A system as claimed in any of claims 1 to 5, wherein said one or more storage units comprise an authentication storage unit, with a user identification database, a storage unit for data concerning the finite element model of a predetermined user, a storage unit for parameters entered via said user interface and a storage unit for result deliveries to the user.

7. A system as claimed in one or more of the preceding claims, wherein said data processing means (4) are of cloud-computing type.

8. A system as claimed in one or more of the preceding claims, wherein said user interface (6) and said result delivering means (43) are included in a Web portal.

9. A system as claimed in one or more of the preceding claims 3 to 8, wherein said one or more storage units include a unit for recording the steps carried out by said processing means into a log that can be accessed through said Web portal.

10. A system as claimed in one or more of the preceding claims 3 to 8, wherein said one or more storage units comprise a unit for storage of a data list concerning base elements that can be used in said finite element model, some parameters of said base elements being at least partially fixed and/or at least partially user-defined elements.
